# EUROPÄISCHE PATENTSCHRIFT

(11) **EP 1 114 442 B1**
(45) Veröffentlichungstag und Bekanntmachung des Hinweises auf die Patenterteilung: **30.10.2002**
(21) Anmeldenummer: 99948699.6
(22) Anmeldetag: 27.07.1999
(51) Int. Cl.: H01L 21/00, C23C 14/22

(54) **VERFAHREN ZUR VERRINGERUNG DER PARTIKELABGABE UND PARTIKELAUFNAHME EINER OBERFLÄCHE**
METHOD FOR REDUCING PARTICLE EMISSION OR ABSORPTION ON A SURFACE
PROCEDE POUR REDUIRE L'EMISSION ET L'ABSORPTION DE PARTICULES D'UNE SURFACE

(30) Priorität: 27.07.1998 DE 19833718
(43) Veröffentlichungstag der Anmeldung: 11.07.2001
(73) Patentinhaber: Fraunhofer-Gesellschaft zur Förderung der angewandten Forschung e.V., 80636 München (DE)
(72) Erfinder: BIRNBAUM, Erwin, D-91058 Erlangen (DE); RYSSEL, Heiner, D-91080 Spardorf (DE); KLUGE, Andreas, D-90482 Nürnberg (DE); RYZLEWICZ, Christoph, D-91052 Erlangen (DE)
(74) Vertreter: Gagel, Roland, Dr.
(86) Internationale Anmeldenummer: DE9902297
(87) Internationale Veröffentlichungsnummer: WO00007223

(56) Entgegenhaltungen:
- KLUGE A, JAVADI B H S, RUOFF H, OCHSNER R, RYSSEL H: "Ion-beam-assisted deposition and ion beam synthesis of wear resistant coatings on technical surfaces" SURFACE AND COATINGS TECHNOLOGY, Bd. 51, Nr. 1-3, 15. April 1992 (1992-04-15), Seiten 237-242, XP000870437
- KENJI SUGIYAMA ET AL: "BASIC CHARACTERISTICS OF CHROMIUM NITRIDE FILMS BY DYNAMIC ION BEAM MIXING" NUCLEAR INSTRUMENTS & METHODS IN PHYSICS RESEARCH, SECTION - B: BEAM INTERACTIONS WITH MATERIALS AND ATOMS,NL,NORTH-HOLLAND PUBLISHING COMPANY. AMSTERDAM, Bd. B80 / 81, Nr. PART 02, 3. Juni 1993 (1993-06-03), Seiten 1376-1379, XP000380420 ISSN: 0168-583X
- PATENT ABSTRACTS OF JAPAN vol. 018, no. 590 (E-1628), 10. November 1994 (1994-11-10) & JP 06 224281 A (TOSHIBA CERAMICS CO LTD;OTHERS: 01), 12. August 1994 (1994-08-12)
- PATENT ABSTRACTS OF JAPAN vol. 018, no. 403 (E-1584), 27. Juli 1994 (1994-07-27) & JP 06 120328 A (HITACHI CHEM CO LTD), 28. April 1994 (1994-04-28)
- GROS R, VON STEBUT J, MICHEL H: "Adhesion optimization of PVD-TiN-coatings due to preceding surface preparation of HSS substrates" EDINBURGH, UK, CEP CONSULTANTS, UK,1987, Seite 215 XP000874543

## Beschreibung

Die Erfindung betrifft ein Verfahren gemäß Anspruch 1 zur Verringerung der Partikelabgabe und Partikelaufnahme einer Oberfläche, insbesondere der Oberfläche einer Waferauflage bei der Halbleiterfertigung.

Im Bereich der Halbleitertechnologie, beispielsweise bei der Bearbeitung und Kontrolle der Fertigung von Schaltkreisen, die unter Reinraumbedingungen erfolgen müssen, stellt die Partikelabgabe von Oberflächen ein großes Problem dar. Es sind daher eine Vielzahl von Reinigungsschritten erforderlich, die die Standzeit der Halbleiterprodukte deutlich erhöhen.

Insbesondere metallische Oberflächen zeigen eine erhöhte Partikelabgabe. Zur Verringerung der durch die Partikelabgabe hervorgerufenen Kontamination und ihrer Auswirkungen wurden Optimierungen an den metallischen Oberflächen vorgenommen, wie beispielsweise das Polieren der metallischen Flächen oder die Verringerung der Berührungsfläche zu den Halbleiterscheiben bzw. Wafern. Mechanische Verbesserungen führen zwar in einigen Fällen zum Erfolg, scheitern jedoch bei Systemen, die besonders empfindlich auf metallische Kontaminationen reagieren oder bei denen eine große Kontaktfläche unvermeidbar ist. Gerade dies ist bei der Halbleiterfertigung der Fall, bei der eine möglichst ebene Auflage einer Silizium-Scheibe auf einem Vakuum-Tisch erforderlich ist. In diesem Fall scheidet daher die Verwendung von Edelstahl und Aluminium, selbst mit polierten Oberflächen, aufgrund der Übertragung metallischer Kontamination aus. Reinst-Aluminium ist zudem wegen seiner nachteiligen mechanischen Eigenschaften kaum einsetzbar, und Aluminiumlegierungen enthalten für eine Dotierung von Silizium unerwünschte Elemente wie z.B. Eisen, Magnesium, Kupfer, Zink oder Chrom.

Ein weiterer Ansatz zur Verminderung der Partikelübertragung besteht darin, Träger und Objekt möglichst materialähnlich auszuführen. So ist beispielsweise der Einsatz eines Quarzträgers als Auflage für einen Silizium-Wafer besonders aussichtsreich. Beim Einsatz dieser Systeme in der Praxis zeigt sich jedoch, daß gerade der Einsatz von Materialien mit ähnlicher Härte infolge eines erhöhten Abriebs zu hoher Partikelübertragung führt.

Es ist weiterhin bekannt, die Partikelabgabe und Partikelaufnahme durch Aufbringen einer Beschichtung auf die Oberfläche des Trägers zu verringern.

Insbesondere weiche Beschichtungen, wie beispielsweise eine Teflon-Beschichtung, können chemisch widerstandsfähig ausgebildet sein und das unerwünschte Abplatzen von kleinen Teilen der Beschichtung weitgehend vermeiden. Weiche Beschichtungen haben jedoch den grundsätzlichen Nachteil, daß vom Objekt eingebrachte Partikel in die weiche Oberfläche eingearbeitet werden. Eine wirksame Reinigung ist hier wegen der besonderen Gefahr einer weiteren Oberflächenschädigung nicht oder nur eingeschränkt möglich. In der Praxis entsteht beim Einsatz weicher Beschichtungen ein Pseudogleichgewicht, bei dem besonders saubere Objekte verunreinigt werden, wenn in Bereichen einer Partikelsättigung der Beschichtung nicht gut genug gereinigt werden kann. Hinzu kommen bei weichen Schichten Nachteile durch elektrostatische Effekte, die gerade beim häufigen Trennen der Objekte von den Oberflächen unvermeidlich scheinen.

Der Einsatz harter Beschichtungen ist vor allem in Verbindung mit Eloxierverfahren bekannt. Zu den harten Beschichtungsverfahren können hierbei alle Verfahren gezählt werden, die eine veränderte Zusammensetzung der Oberfläche gegenüber dem ursprünglichen Trägermaterial ergeben.

Eines der am häufigsten angewendeten Verfahren ist das Eloxieren. Genauere Untersuchungen haben jedoch ergeben, daß eloxierte Oberflächen aufgrund von Haftungsproblemen zwischen Eloxal und Träger das Problem der Partikelabgabe ebenfalls nicht zufriedenstellend lösen können. Bei eloxierten Oberflächen tritt insbesondere an Kanten, wie beispielsweise an den Grenzen von Vakuumkanälen bei Waferauflagen, eine erhöhte Partikelabgabe auf.

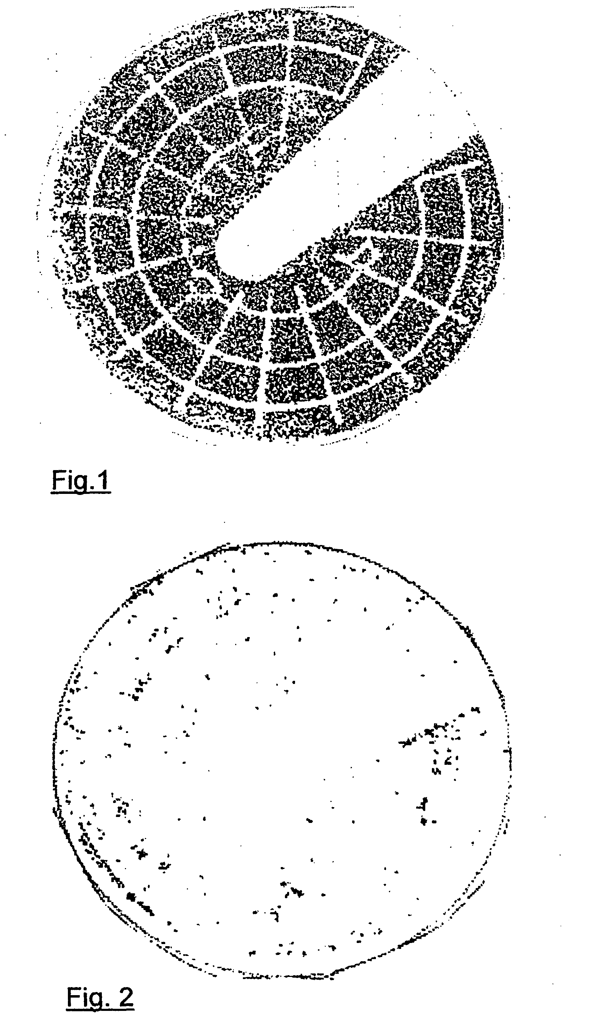

Figur 1 zeigt eine Messung der Partikelverteilung und Anzahl der Partikel auf einem Wafer, der auf einer Eloxalunterlage auflag, in graphischer Darstellung. In der Figur sind die Stellen mit hoher Partikelanhäufung deutlich zu erkennen. Es zeichnen sich die Kantenverläufe (Vakuumkanäle) und eine große Aussparung der Unterlage ab. Bei der Betrachtung der Figur muß berücksichtigt werden, daß gewöhnlich kleine Partikel (0,1 µm bis ca. 1 µm) für eine graphische Darstellung um den Faktor 10 bis 1000 vergrößert dargestellt werden müssen. Dies führt bei hohen Partikelzahlen oft zum falschen Eindruck einer flächenhaften Betroffenheit. Bei der dargestellten Messung kann eine Fehlinterpretation aufgrund einer Waferbeschädigung einschließlich Waferrauhigkeit (Haze) ausgeschlossen werden, so daß es sich bei den geschwärzten Bereichen überwiegend um Partikel handelt. Dies konnte dadurch verifiziert werden, daß nur Messungen an den polierten Vorderseiten der Wafer durchgeführt wurden, und zwar vor und nach dem Kontakt mit der Beschichtung.

Wie bereits einleitend angeführt können Reinigungsschritte zwar kurzzeitige Besserung erzielen, vergrößern jedoch unerwünschterweise die Standzeiten bei der Fertigung.

Die Aufgabe der vorliegenden Erfindung besteht darin, ein Verfahren zur Verringerung der Partikelabgabe und Partikelaufnahme einer Oberfläche anzugeben.

Die Aufgabe wird mit dem Verfahren gemäß Patentanspruch 1 gelöst. Vorteilhafte Weiterbildungen des Verfahrens sind Gegenstand der Unteransprüche.

Erfindungsgemäß wurde trotz der bei harten Schichten, wie der obigen eloxierten Schicht, weiterhin auftretenden Probleme der Partikelübertragung erkannt, daß ein besonderes Verfahren der Schichterzeugung von harten Schichten die Partikelabgabe und Partikelaufnahme der Beschichtung deutlich verringern kann. Diese deutliche Verringerung der Partikelübertragung wird durch eine Beschichtung der Oberfläche erreicht, die in einem Hochvakuum durch gleichzeitige Bedampfung der Oberfläche mit Feststoffatomen und Beschuß mit Ionen erzeugt wird. Die Feststoffatome und die Ionen werden hierbei in einem stöchiometrischen Verhältnis auf die Oberfläche aufgebracht. Vor der Beschichtung wird die Oberfläche gereinigt und gegebenenfalls entfettet.

Vorzugsweise werden bei Oberflächen, die scharfe Kanten oder Grate aufweisen, diese Kanten oder Grate vor der Beschichtung abgerundet. Dies kann beispielsweise mit einem Glasperlengebläse erfolgen.

Die erfindungsgemäße Verwendung des dargestellten Beschichtungsverfahrens ermöglicht in vorteilhafter Weise die Verringerung der Partikelabgabe und Partikelaufnahme einer Oberfläche. Hierdurch verringert sich beispielsweise bei der Halbleiterfertigung der Reinigungsaufwand der Arbeitsfläche und die Standzeit, d.h. die Gebrauchszeit bis zur nächsten Überholung/Wartung, der beschichteten Oberfläche verlängert sich. Selbst bei vergleichbarer Anzahl von Reinigungsschritten im Vergleich zu bisher eingesetzten Beschichtungen wird die Standzeit verlängert, da der Reinigungsaufwand aufgrund verminderter Kontaminationen geringer ausfällt.

Insbesondere für die Anwendung in der Halbleitertechnologie ist es von Vorteil, daß die Beschichtung auch auf einer handelsüblichen Vakuumauflage (Chuck) ohne weitere Vorbereitungen aufgebracht werden kann.

Das erfindungsgemäße Verfahren beruht auf einer gleichmäßigen Aufbringung der Schicht bzw. Beschichtung, wobei die Ionen und Feststoffatome in stöchiometrischem Verhältnis, vorzugsweise mit jeweils gleichen Anteilen im stöchiometrischen Verhältnis 1:1, aufgebracht werden. Ein wesentliches Merkmal ist dabei die gleichzeitige Bedampfung und der Beschuß mit Ionen. Dadurch wird ein Eindringen der Ionen und des Verdampfungsmaterials in die Oberfläche, beispielsweise des Auflagerohlings, erreicht. Es entsteht somit keine scharfe Trennung zwischen der Materialoberfläche des Rohlings und der Bedampfungsschicht, sondern infolge des gleichzeitigen Ionenbeschusses ein Vermischen der Komponenten in den oberflächennahen Schichten. Es handelt sich hierbei um ein ionenstrahlgestütztes Aufdampfen (IBAD - ion beam assisted deposition).

Das erfindungsgemäße Verfahren wird nachfolgend anhand eines Ausführungsbeispiels in Verbindung mit den Zeichnungen näher erläutert. Hierbei zeigen:
- Figur 1: in graphischer Darstellung eine Messung der Partikelverteilung und der Anzahl der Partikel auf einem Wafer, der auf einer Eloxalunterlage gemäß dem Stand der Technik auflag;
- Figur 2: in graphischer Darstellung eine Messung der Partikelverteilung und der Anzahl der Partikel auf einem Wafer, der auf einer gemäß der vorliegenden Erfindung beschichteten Unterlage auflag; und
- Figur 3: eine beispielhafte Anordnung zur Beschichtung einer Oberfläche gemäß dem erfindungsgemäßen Verfahren.

Im folgenden Ausführungsbeispiel wird ein Auflagerohling in Form einer handelsüblichen Vakuumauflage für Wafer mit dem erfindungsgemäßen Verfahren behandelt.

Die wesentlichen Vorteile der mit dem Verfahren erzeugten Beschichtung werden durch die Verwendung der besonderen Beschichtungstechnik erzielt. Bei der Anwendung des erfindungsgemäßen Verfahrens wird vorzugsweise zunächst eine Abrundung von üblicherweise scharfen Kanten der Oberfläche des Rohlings durchgeführt. Dies führt in vorteilhafter Weise zu einer zusätzlich verbesserten Haftung der Schicht. Danach ist eine sorgfältige Entfettung mit Reinigung des Rohlings notwendig. Dies ist Voraussetzung für das Gelingen der Beschichtung unter Hochvakuumbedingungen.

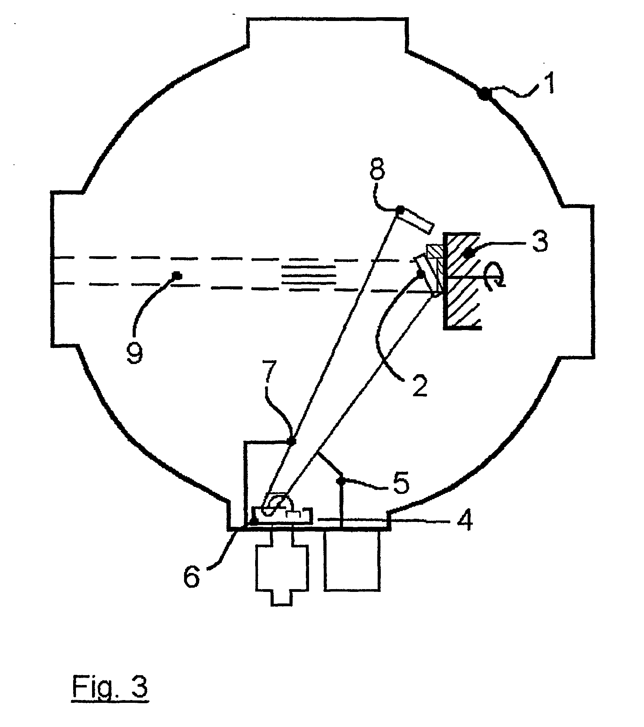

Das Prinzip der Erzeugung der Beschichtung wird anhand von Figur 3 dargestellt. Figur 3 zeigt in Seitenansicht eine beispielhafte Anordnung zur Beschichtung einer Oberfläche gemäß dem erfindungsgemäßen Verfahren. In einer Vakuumkammer 1 ist der Rohling 2 mit der zu beschichtenden Oberfläche auf einer drehbaren Halterung 3 angeordnet. Über eine Elektronen-Verdampfungseinheit 4 in einem wassergekühlten Gehäuse 5 wird der in einem Tiegel 6 befindliche Feststoff verdampft, so daß die Feststoffatome über eine Öffnung 7 zur Oberfläche des Rohlings gelangen können. Die Entwicklung der Schichtdicke und die Aufdampfrate können über einen Detektor 8 erfaßt werden. Gleichzeitig mit der Bedampfung der Oberfläche wird diese mit einem in der Figur gestrichelt dargestellten Ionenstrahl 9 beaufschlagt.

Als Beschichtungsanlage für das Ausführungsbeispiel dient ein Ionenimplanter, der zusätzlich mit einer handelsüblichen Elektronenstrahlverdampfungseinheit ausgerüstet ist. Der gereinigte und entfettete Auflagerohling wird mittels eines mechanischen Verfahrtisches sowohl horizontal als auch vertikal unter dem Ionenstrahl bewegt. Der Ionenstrahl wird im vorliegenden Beispiel mit einer Beschleunigungsspannung von ca. 50 kV beschleunigt und weist eine Stromstärke von ca. 5 mA auf. Die Aufdampfrate beträgt 7 Ångström/s. Mit diesen Parametern können Schichtdicken bis zu einigen µm erzeugt werden. Im vorliegenden Beispiel wurde mit Stickstoff-Ionen und verdampften Titan-Atomen unter Einhaltung einer 1:1 Stöchiometrie eine TitannitridSchicht mit einer Schichtdicke von 0,3 µm auf einem Werkstückträger (Chuck) aus einer Aluminiumlegierung erzeugt.

Das Material der aufgebrachten Schicht, TiN, das im Bereich des Maschinenbaus weithin zur Oberflächenveredelung eingesetzt wird, erhält bei dieser besonderen Art der Schichterzeugung außerordentlich gute Eigenschaften in bezug auf Haftfestigkeit und Verzahnung mit dem Untergrund. Voraussetzung für die sehr gute Haftfestigkeit ist in diesem Beispiel der Einsatz von Ionenenergien im Bereich von 50 keV, wodurch das schon erzeugte Schichtmaterial ständig atomar in das Substrat eingemischt wird. Hinzu kommt der Effekt, daß die Materialeigenschaften der Oberflächenschicht gleitend in die des Substrats übergehen.

Für die Schichtdicke genügen wenige zehntel Mikrometer, um die gewünschten Eigenschaften hinsichtlich der Verringerung der Partikelaufnahme und -abgabe zu erreichen.

Als Material für die Beschichtung eignet sich weiterhin insbesondere Silizium in Verbindung mit Kohlenstoff zur Erzeugung einer SiC-Schicht.

Die Auswirkung des Einsatzes der auf diese Weise erzeugten TiN-Schicht auf die Partikelübertragung zeigt Figur 2, die in Vergleich zu Figur 1 zu sehen ist.

Die in Figur 1 gezeigte graphische Darstellung einer Messung der Partikelverteilung und Anzahl der Partikel auf einem Wafer, der auf einer Eloxalunterlage gemäß dem Stand der Technik auflag, wurde einleitend bereits eingehend erläutert.

Im Vergleich hierzu zeigt Figur 2 in graphischer Darstellung eine Messung der Partikelverteilung und der Anzahl der Partikel auf einem Silizium-Wafer, der auf der gemäß dem Ausführungsbeispiel beschichteten Unterlage auflag. Hierbei sind bei vergleichbarer Meßempfindlichkeit deutlich kleinere Partikelanhäufungen und insgesamt wesentlich weniger Partikel auf der Waferoberfläche zu finden. Konkret wurden auf dem Wafer der Figur 1 33159 Partikel gemessen, auf dem Wafer der Figur 2 bei leicht erhöhter Empfindlichkeit 772 Partikel. Somit ergibt sich bei Einsatz des erfindungsgemäßen Verfahrens eine Verminderung der Gesamtpartikelzahl um etwa den Faktor 40. Außerdem ist in Figur 2 deutlich erkennbar, daß sich die Partikelanhäufung um die Vakuumkanäle stark reduziert hat. Aufgrund der sehr guten Verbindung der Schicht mit dem Untergrund ist auch hier selbst an kritischen Stellen eine deutliche Partikelreduzierung zu erkennen. Die Beschichtung ist auch für Vakuumauflagen geeignet, bei denen ein erhöhter Auflagedruck gewünscht wird.

Das erfindungsgemäße Verfahren ermöglicht somit die Erzeugung einer Beschichtung, die sich äußerst partikelarm verhält. Die Beschichtung enthält keine schädlichen Legierungselemente für die Halbleitertechnologie und ist chemisch beständig. Sie kann auf handelsüblichen Grundmaterialien (Rohlingen), wie z.B. Aluminium, Titan u.a., aufgebracht werden und erfordert keine aufwendigen Vorbereitungen oder stellt keine besonderen Anforderungen an die Untergrundoberfläche.

Die nach dem erfindungsgemäßen Verfahren erzeugte Beschichtung haftet nicht nur auf dem Untergrund, sondern geht mit dem Untergrund eine Tiefenverbindung ein. Aufgrund dieser Tiefenverbindung zeigt die Beschichtung keine Rißbildung. Durch ihre günstigen Oberflächeneigenschaften ist die Partikelaufnahme und -abgabe der Oberfläche deutlich reduziert. Eingeschleppte Partikel lassen sich mit einfachsten Reinigungsmethoden ohne Beschädigung der Schicht leicht entfernen.

## Patentansprüche

1. Verfahren zur Verringerung der Partikelabgabe und Partikelaufnahme einer Oberfläche für die Halbleiterfertigung unter Reinraumbedingungen, insbesondere der Oberfläche einer Waferauflage, mit folgenden Schritten:
- Reinigen und/oder Entfetten der Oberfläche;
- Erzeugen eines Hochvakuums; und
- Gleichzeitige Bedampfung der Oberfläche mit Feststoffatomen und Beschuß mit Ionen,
wobei die Feststoffatome und die Ionen in einem stöchiometrischen Verhältnis zueinander auf die Oberfläche aufgebracht werden und so gewählt sind, daß sie eine harte Schicht bilden.

2. Verfahren nach Anspruch 1,
**dadurch gekennzeichnet,**
**daß** vor dem Reinigen und/oder Entfetten scharfe Kanten an der Oberfläche abgerundet werden.

3. Verfahren nach Anspruch 1 oder 2,
**dadurch gekennzeichnet,**
**daß** die Bedampfung der Oberfläche mittels einer Elektronen-Verdampfungseinheit erfolgt.

4. Verfahren nach einem der Ansprüche 1 bis 3,
**dadurch gekennzeichnet,**
**daß** die Feststoffatome und die Ionen so gewählt sind, daß die harte Schicht einen Wärmeausdehnungskoeffizienten aufweist, der dem der Oberfläche ähnlich ist.

5. Verfahren nach einem der Ansprüche 1 bis 4,
**dadurch gekennzeichnet,**
**daß** die Feststoffatome und die Ionen so gewählt sind, daß sie eine TiN- oder eine SiC-Schicht auf der Oberfläche bilden.

6. Verfahren nach einem der Ansprüche 1 bis 5,
**dadurch gekennzeichnet,**
**daß** die harte Schicht mit einer Schichtdicke von weniger als einem Mikrometer gebildet wird.

7. Verfahren nach einem der Ansprüche 1 bis 6,
**dadurch gekennzeichnet,**
**daß** die Oberfläche die Oberfläche eines Auflagerohlings für Wafer ist.

## Claims

1. A process for the reduction of the giving off and the collecting of particles of a surface for semiconductor production under clean-room conditions, in particular of the surface of a wafer support, having the following steps:
- cleaning and/or degreasing the surface;
- producing a high vacuum; and
- simultaneous vapor deposition of said surface with solid matter atoms
and impingement with ions, with said solid matter atoms and said ions being applied to the surface in a stoichiometric ratio and being selected in such a manner that they form a hard coating.

2. A process according to claim 1,
**characterized by**
the sharp edges of said surfaces being rounded off before said cleaning and/or degreasing.

3. A process according to claim 1 or 2,
**characterized by**
said vapor deposition of said surface occurring by means of an electron vaporization unit.

4. A process according to one of the claims 1 to 3,
**characterized by**
said solid matter atoms and said ions being selected in such a manner that said hard coating has a thermal expansion coefficient which is similar to that of said surface.

5. A process according to one of the claims 1 to 4,
**characterized by**
said solid matter atoms and said ion being selected in such a manner that they form a TiN coating or a SiC coating on said surface.

6. A process according to one of the claims 1 to 5,
**characterized by**
said hard coating being formed with a layer thickness of less than one micrometer.

7. A process according to one of the claims 1 to 6,
**characterized by**
said surface being the surface of a support blank for a wafer.

## Revendications

1. Procédé de réduire le dégagement de particules et le captage de particules d'une surface pour la fabrication de semi-conducteurs aux conditions ultra-pures, en particulier de la surface d'un support de galettes, comprenant les opérations suivantes:
- nettoyage et/ou dégraissage de la surface;
- création d'un fort vide, et
- métallisation simultanée de la surface moyennant des atomes de matière solide et par bombardement ionique,
dans lequel les atomes de matière solide et les ions sont déposés en un rapport stoïchiométrique l'un à l'autre sur la surface, en étant choisis de façon, qu'ils forment une couche dure.

2. Procédé selon la revendication 1,
**caractérisé en ce**
**que** des arêtes vives à la surface sont arrondies avant le nettoyage et/ou le dégraissage.

3. Procédé selon la revendication 1 ou 2,
**caractérisé en ce**
**que** la métallisation de la surface se fait moyennant une unité de vaporisation électronique.

4. Procédé selon une quelconque des revendications 1 à 3,
**caractérisé en ce**
**que** les atomes de matière solide et les ions sont choisis de façon, que la couche dure présente un coefficient de dilatation thermique similaire au coefficient de la surface.

5. Procédé selon une quelconque des revendications 1 à 4,
**caractérisé en ce**
**que** les atomes de matière solide et les ions sont choisis de façon, qu'ils forment une couche en TiN ou une couche en SiC sur la surface.

6. Procédé selon une quelconque des revendications 1 à 5,
**caractérisé en ce**
**que** la couche dure est formée à une épaisseur de couche de moins d'un micromètre.

7. Procédé selon une quelconque des revendications 1 à 6,
**caractérisé en ce**
**que** la surface est la surface d'une ébauche de support pour des galettes.
